# EUROPÄISCHE PATENTANMELDUNG

(11) **EP 1 330 005 A1**
(43) Veröffentlichungstag der Anmeldung: **23.07.2003**
(21) Anmeldenummer: 02000813.2
(22) Anmeldetag: 14.01.2002
(51) Int. Cl.: H02H 3/04

(54) **Verfahren und Schaltungsanordnung zur Überwachung physikalischer Grössen, insbesondere zum Einsatz in Telekommunikationseinrichtungen**

(71) Anmelder: SIEMENS AKTIENGESELLSCHAFT, 80333 München (DE)
(72) Erfinder: Seitz, Hans-Juergen, 82335 Berg (DE)

(57) **Zusammenfassung**

Bei Digitalbaugruppen wird die Versorgungsspannung (U1, U2) durch einen Spannungsüberwachungsbaustein (RG1, RG2) überwacht. Weicht die Versorgungsspannung (U1, U2) von ihrem Sollwertebereich ab, so löst der Spannungsüberwachungsbaustein (RG1, RG2) einen Reset der gesamten Digitalbaugruppe aus, um undefinierte Logik-Zustände zu verhindern. Ebenso wird während des Einschaltens der Versorgungsspannung (U1, U2) ein Power-On Reset-Signal erzeugt, was bewirkt, daß die Digitalbaugruppe erst nach einer definierten Zeit in den Betriebszustand übergeht. Für Systeme, an deren Ausfallsicherheit bestimmte Mindestanforderungen gestellt werden, ist es üblich, eine Online-Diagnose durchzuführen. Es ist wünschenswert, auch den Spannungsüberwachungsbaustein (RG1, RG2) in diese Online-Diagnose einzubeziehen. Ein Test der Spannungsüberwachung erzeugt jedoch den gleichen Power-On Reset wie z.B. das Einschalten, und ein "echter" Power-On Reset ist nur sehr schwer von einem "simulierten" zu unterscheiden. Erfindungsgemäß wird dies gelöst, indem die Überwachung durch mindestens zwei unabhängige Überwachungsbausteine (RG1, RG2) erfolgt, deren Signale durch Verknüpfungsmittel (V1, V2, V3, V4) verknüpft werden. Dies ermöglicht das Testen der zwei unabhängigen Überwachungsbausteine (RG1, RG2) unabhängig voneinander.

## Beschreibung

Die Erfindung betrifft eine Schaltungsanordnung und ein Verfahren zur Überwachung physikalischer Größen sowie ein Verfahren zur Diagnose der erfindungsgemäßen Schaltungsanordnung, insbesondere zum Einsatz in Telekommunikationseinrichtungen.

Bei Digitalbaugruppen wird die Versorgungsspannung durch einen Spannungsüberwachungsbaustein überwacht. Erreicht bzw. überschreitet die Abweichung der Versorgungsspannung von ihrem Sollwert einen bestimmten Schwellwert, so löst der Spannungsüberwachungsbaustein einen Reset der gesamten Digitalbaugruppe aus, im folgenden als Power-On Reset bezeichnet, um undefinierte Logik-Zustände zu verhindern. Ebenso wird während des Einschaltens der Versorgungsspannung die gesamte Digitalbaugruppe mit einem Power-On Reset-Signal versorgt, was bewirkt, daß die Digitalbaugruppe erst nach einer definierten Zeit bzw. bei Erreichen eines stabilen Zustandes der Versorgungsspannung in den Betriebszustand übergeht.

Für Systeme, an deren Ausfallsicherheit bestimmte Mindestanforderungen gestellt werden, ist es üblich, mittels eingebauter oder externer Mechanismen in regelmäßigen Zeitabständen und/oder auf Bedieneranforderung im laufenden Betrieb eine Diagnose bzw. Selbsttest durchzuführen, die allgemein als Online-Diagnose bezeichnet wird. Es ist wünschenswert, auch den Spannungsüberwachungsbaustein in diese Online-Diagnose einzubeziehen, da gerade diese Bausteine eine relativ hohe Fehlerwahrscheinlichkeit aufweisen, d.h. Spannungsüberwachungsbausteine weisen eine relativ hohe FIT Rate - Failure in Time Rate - (Ausfallrate) auf.

Soll im Rahmen einer Online-Diagnose der Spannungsüberwachungsbaustein auf korrekte Funktionalität getestet werden, d.h. durch Aufprägen eines dafür vorgesehenen Signals auf einen entsprechenden Signaleingang des Spannungsüberwachungsbausteins wird beispielsweise eine Schwankung der Versorgungsspannung simuliert, woraufhin der Spannungsüberwachungsbaustein ein aktives Power-On Reset-Signal erzeugt, so führt dieses Power-On Reset-Signal ebenfalls zum Rücksetzen der gesamten Logik einer Baugruppe inklusive der darauf befindlichen Prozessoren. Einer dieser Prozessoren wird den Test der Spannungsüberwachung normalerweise als einen Testschritt im Rahmen des gesamten Diagnose-Ablaufs auslösen. Da dieser Test jedoch den gleichen Power-On Reset wie z.B. das Einschalten oder eine starke Schwankung der Versorgungsspannung auslöst, ist es für den Prozessor nur sehr schwer zu unterscheiden, ob die Baugruppe gerade eingeschaltet wurde - "echter" Power-On Reset - oder ob ein Test des Spannungsüberwachungsbausteins - "simulierter" Power-On Reset - für den Power-On Reset verantwortlich war.

Des weiteren schließt sich an einen Power-On Reset der Initialisierungsvorgang der Baugruppe an. Dieser Initialisierungsvorgang bzw. Hochlauf der Baugruppe nach einem Power-On Reset benötigt eine nicht unerhebliche Zeitspanne, falls z.B. große Speicherbereiche zu formatieren sind oder große Datenmengen aus langsamen nichtflüchtigen Speichern in den Arbeitsspeicher geladen werden.

Bekannte Lösungen dieses Problems verwenden ein Speicherregister, z.B. einen statische RAM Speicher, der durch einen reinen Reset ohne Spannungsunterbrechung nicht gelöscht wird, um eine Unterscheidung zwischen "echtem" und "simuliertem" Power-On Reset durchzuführen. Dieses Register wird nach jedem Power-On Reset gelesen. Es werden drei Fälle unterschieden:
- In dem Speicherregister steht das "Test-Datenmuster". Dies ist das Indiz für einen "simulierten" Power-On Reset im Rahmen einer Online-Diagnose, die an dieser Stelle fortgesetzt wird.
- In dem Speicherregister steht das "Betriebs-Datenmuster". Dies ist das Indiz für einen "echten" Reset, der z.B. aufgrund einer Spannungsschwankung durch den Spannungsüberwachungsbaustein oder durch einen Baugruppen-Reset ausgelöst wurde.
- In dem Speicherregister steht weder das "Test-Datenmuster" noch das "Betriebs-Datenmuster". Dies ist das Indiz für einen "echten" Power-On Reset nach Einschalten der Versorgungsspannung. Der Prozessor beschreibt das Register nun sofort mit dem "Betriebs-Datenmuster", und es erfolgt ein gewöhnlicher Baugruppen-Hochlauf.

Die Unterscheidung dieser drei Fälle ist jedoch, bedingt z.B. durch physikalische Effekte, nicht in allen Fällen eindeutig. Beispielsweise ist nicht festgelegt, wie lange ein statischer RAM Speicher ein Datenmuster auch ohne Betriebsspannung beibehält. So kann es vorkommen, daß das Speicherregister noch das "Betriebs-Datenmuster" enthält, obwohl die Baugruppe für einen längeren Zeitraum, unter Umständen mehrere Minuten, abgeschaltet war. Auch können Fälle, in denen das "Test-Datenmuster" bereits in das Speicherregister eingeschrieben ist und der Reset allerdings nicht durch das Testsignal, sondern eine zufällig auftretende Spannungsschwankung ausgelöst wird, nicht unterschieden werden von Fällen, in denen der Reset durch das Testsignal ausgelöst wird.

Aufgabe der vorliegenden Erfindung ist es, die bekannten Verfahren und Schaltungsanordnungen zur Überwachung physikalischer Größen zu verbessern.

Diese Aufgabe wird durch die Merkmale der Patenansprüche 1 sowie 9 gelöst.

Bevorzugte Ausführungsformen sind Gegenstand der abhängigen Ansprüche.

Erfindungsgemäß wird die Aufgabe durch eine Schaltungsanordnung gelöst, die folgendes umfaßt:
- einen ersten Überwachungsbaustein RG1 zur Überwachung mindestens einer physikalischen Größe U1, U2 mit Mitteln zur Zuführung eines Signals bei Abweichung der überwachten physikalischen Größe U1, U2 von deren vorgegebenem Sollwertebereich über erste Ausgabesignalleitungsmittel PON_RES1_L_I zu einer Auswerteschaltung A und ersten Eingabesignalleitungsmitteln PON_TEST1_L_O zur Eingabe eines ersten Testsignals, wobei durch das erste Testsignal derselbe Zustandswechsel des ersten Überwachungsbausteins RG1 erzeugbar ist wie durch eine Abweichung der überwachten physikalischen Größe von ihrem Sollwertebereich,
- mindestens einen weiteren Überwachungsbaustein RG2 zur Überwachung der gleichen physikalischen Größe U1, U2 mit Mitteln zur Zuführung eines Signals bei Abweichung der überwachten physikalischen Größe U1, U2 von deren vorgegebenem Sollwertebereich über weitere Ausgabesignalleitungsmittel PON_RES2_L_I zu der Auswerteschaltung A und weiteren Eingabesignalleitungsmitteln PON_TEST2_L_O zur Eingabe eines weiteren Testsignals, wobei durch das weitere Testsignal derselbe Zustandswechsel des weiteren Überwachungsbausteins RG2 erzeugbar ist wie durch eine Abweichung der überwachten physikalischen Größe von ihrem Sollwertebereich,
- der Auswerteschaltung A zugeordnete Verknüpfungsmittel V1 zur Verknüpfung der über die ersten Ausgabesignalleitungsmittel PON_RES1_L_I und die weiteren Ausgabesignalleitungsmittel PON_RES2_L_I zugeführten Signale zu einem resultierenden Ausgabesignal PON_RES,
- der Auswerteschaltung A zugeordnete erste Registermittel RTR zum separaten Aufprägen des ersten Testsignals auf die ersten Eingabesignalleitungsmittel PON_TEST1_L_O und des zweiten Testsignals auf die weiteren Eingabesignalleitungsmittel PON_TEST2_L_O, wobei die ersten Registermittel RTR Mittel zum Empfang von Steuerungsinformationen SI von Steuerungsmitteln S aufweisen,
- der Auswerteschaltung A zugeordnete zweite Registermittel RIR, die an die ersten Ausgabesignalleitungsmittel PON_RES1_L_I und die weiteren Ausgabesignalleitungsmittel PON_RES2_L_I angeschlossen sind und Mittel zur Übertragung von Zustandsinformationen ZI an die Steuerungsmittel S aufweisen,
- die der Auswerteschaltung A zugeordneten Steuerungsmittel S, die Mittel zum Auswerten von Zustandsinformationen ZI der zweiten Registermittel RIR und Mittel zum Senden von Steuerungsinformationen SI an die ersten Registermittel RTR umfassen.

Ein wesentlicher Vorteil dieser verbesserten Schaltungsanordnung wird darin gesehen, daß die Überwachung durch mindestens zwei unabhängige Überwachungsbausteine RG1, RG2 erfolgt, so daß bei geeigneter Wahl der Verknüpfungsmittel V1 der Auswerteschaltung A verbesserte Ergebnisse gegenüber einer Schaltungsanordnung mit nur einem Überwachungsbaustein erzielt werden. Insbesondere ist es möglich, die mindestens zwei unabhängigen Überwachungsbausteine RG1, RG2 unabhängig voneinander zu testen. Damit wird ein signifikanter Vorteil gegenüber bekannten Lösungen erzielt, der darin besteht, daß die Überwachungsbausteine RG1, RG2 getestet werden können, ohne einen Reset bzw. ein Rücksetzen der gesamten Digitalbaugruppe einschließlich der Testlogik bzw. Diagnoselogik auszulösen.

Vorteilhaft werden dazu die Signale der Überwachungsbausteine mittels logischer UND-Funktion verknüpft - Anspruch 2. Somit kann nur ein durch die mindestens zwei Überwachungsbausteine RG1, RG2 gleichzeitig festgestellter Zustand ein gültiges Reset-Signal PON_RES für die Digitalbaugruppe erzeugen. Ein einzelnes Reset-Signal einer der Überwachungsbausteine im Rahmen eines Tests dieses Bausteins hingegen löst keinen Reset der gesamten Digitalbaugruppe aus.

Um die Zuverlässigkeit der Auswerteschaltung A zu gewährleisten und Ausfälle zu detektieren, wird die Auswerteschaltung in die Selbsttest- bzw. Diagnosestrategie der übergeordneten Einheit mit einbezogen - Ansprüche 3 und 4. Insbesondere für applikationsspezifische integrierte Schaltungen, sog. ASICs, stehen in Form des Built-In Self Test Verfahren und schaltungstechnische Realisierungen bereit, die auf einfache Weise auf die Auswerteschaltung A oder Teile der Auswerteschaltung A angewendet werden können - Anspruch 4.

Die Schaltungsanordnung ist vorteilhaft zur Überwachung aller physikalischen Größen geeignet, bei denen das Verlassen eines Sollwertebereichs z.B. aus Sicherheitsgründen oder um Beschädigungen der Baugruppe zu verhindern einen Reset erfordert, sowie zum Testen der entsprechenden Überwachungsbausteine - Anspruch 5.

Für elektronische Baugruppen von besonderer Bedeutung ist die Überwachung elektrischer Spannungen, elektrischer Ströme und Temperaturen - Anspruch 6. Im Fall der Überwachung elektrischer Spannungen können so undefinierte Logikzustände vermieden werden. Werden elektrische Ströme und/oder Temperaturen überwacht, können durch Unterbrechen des laufenden Betriebs Beschädigungen durch zu hohe Verlustleistungen verhindert werden.

In elektronischen Logikbaugruppen treten üblicherweise zwei elektrische Spannungen U1, U2 auf, die zur Versorgung der Logikbausteine dienen. Gemäß Anspruch 7 werden diese beiden Spannungen jeweils von beiden Überwachungsbausteinen überwacht.

Für getaktete elektronische Logikbaugruppen, die mit hohen Taktfrequenzen betrieben werden, ist es erforderlich, vor dem Aktivieren der Schaltungslogik stabile Taktzustände zu erreichen. Gemäß Anspruch 8 werden über verschiedene Ausgabesignalleitungsmittel Reset-Signale mit jeweils eigenem Zeitverhalten vorgesehen, so daß ein gegenüber dem Aufheben des Reset-Signals für die takterzeugenden Schaltungsteile verzögertes Aufheben des Reset-Signals für die Schaltungslogik möglich ist.

Ein Testen der Überwachungsbausteine RG1, RG2 wird durchgeführt, indem:
- in einem ersten Schritt durch die Steuerungsmittel S der erste Überwachungsbaustein RG1 ausgewählt wird,
- in einem zweiten Schritt diese Auswahl repräsentierende Steuerungsinformationen SI an die ersten Registermittel RTR übertragen werden,
- in einem dritten Schritt ein Testsignal mittels der ersten Eingabesignalleitungsmittel PON_TEST1_L_O an den ersten Überwachungsbaustein RG1 übertragen wird,
- in einem vierten Schritt die von den zweiten Registermitteln RIR erzeugten Zustandsinformationen ZI, welche die Signale der Ausgabesignalleitungsmittel PON_RES1_L_I, PON_RES2_L_I repräsentieren, durch die Steuerungsmittel S empfangen und daraufhin überprüft werden, daß das Signal der ersten Ausgabesignalleitungsmittel PON_RES1_L_I ein gültiges Reset-Signal bzw. Rücksetzsignal ist und daß das Signal der weiteren Ausgabesignalleitungsmittel PON_RES2_L_I ein beliebiges gültiges, vom Reset-Signal unterschiedliches Signal ist,
- in einem fünften Schritt nach Ablauf einer vorgebbaren Zeitspanne, deren Ablauf mit dem Feststellen eines gültigen Reset-Signals in Schritt vier beginnt, durch die Steuerungsmittel S überprüft wird, daß das Signal der ersten Ausgabesignalleitungsmittel PON_RES1_L_I zu einem beliebigen gültigen, vom Reset-Signal unterschiedlichen Signal zurückkehrt,
- die Schritte eins bis fünf für alle weiteren Überwachungsbausteine RG2 entsprechend wiederholt werden.

Mit Hilfe dieses Verfahrens kann die erfindungsgemäße Schaltungsanordnung vorteilhaft eingesetzt werden, um die mindestens zwei unabhängigen Überwachungsbausteine RG1, RG2 unabhängig voneinander zu testen. Damit wird ein signifikanter Vorteil gegenüber bekannten Lösungen erzielt, der darin besteht, daß die Überwachungsbausteine RG1, RG2 getestet werden können, ohne einen Reset der gesamten Digitalbaugruppe einschließlich der Testlogik bzw. Diagnoselogik auszulösen.

Im folgenden wird die erfindungsgemäße Schaltungsanordnung und das erfindungsgemäße Verfahren als Ausführungsbeispiel anhand von zwei Zeichnungen näher erläutert.

Fig. 1 ist eine schematische Darstellung der erfindungsgemässen Schaltungsanordnung, anhand derer das Prinzip der Erfindung für die Überwachung einer physikalischen Größe, bei der es sich hier um eine elektrische Spannung U1 handelt, erläutert wird.
Fig. 2 ist eine schematische Darstellung einer Anwendung der erfindungsgemäßen Schaltungsanordnung zur Überwachung zweier elektrischer Spannungen U1, U2.

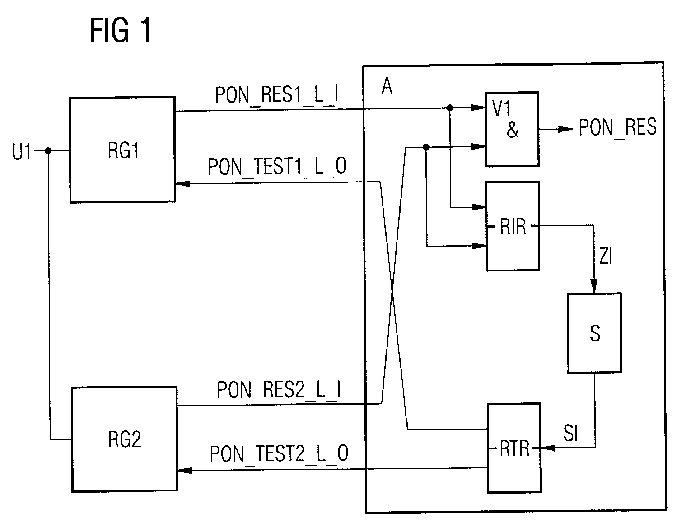

In Fig. 1 ist eine zu überwachende elektrische Spannung U1 dargestellt, die von einem ersten Power-On Reset-Generator RG1 (im folgenden Spannungsüberwachungsbaustein RG1) und einem zweiten Power-On Reset-Generator RG2 (im folgenden Spannungsüberwachungsbaustein RG2) überwacht wird. Bei Abweichung der Spannung U1 von einem vorgegebenen Sollwertebereich, z.B. Nennwert 5 Volt mit einer zulässigen Abweichung von ± 5 Prozent vom Nennwert, erzeugt der erste Spannungsüberwachungsbaustein RG1 ein Reset-Signal auf einer ersten Reset-Leitung PON_RES1_L_I (für: Power-On_Reset1_Low-active_Input), die eine Ausgangsleitung des ersten Spannungsüberwachungsbausteins RG1 ist, und der zweite Spannungsüberwachungsbaustein RG2 erzeugt ein Reset-Signal auf einer zweiten Reset-Leitung PON_RES2_L_I (für: Power-On_Reset2_Low-active_Input), die eine Ausgangsleitung des zweiten Spannungsüberwachungsbausteins RG2 ist.

Der erste Spannungsüberwachungsbaustein RG1 weist eine Eingangsleitung PON_TEST1_L_O (für: Power-On_Test1_Low-active_Output) auf, über die ein erstes Testsignal in den ersten Spannungsüberwachungsbaustein RG1 eingebbar ist. Ein Eingeben des ersten Testsignals in den ersten Spannungsüberwachungsbaustein RG1 bewirkt einen Selbsttest des Spannungsüberwachungsbausteins RG1, woraufhin durch diesen ein gültiges Reset-Signal auf der ersten Reset-Leitung PON_RES1_L_I ausgegeben wird.

Der zweite Spannungsüberwachungsbaustein RG2 weist eine Eingangsleitung PON_TEST2_L_O (für: Power-On_Test2_Low-active_Output) auf, über die ein zweites Testsignal in den zweiten Spannungsüberwachungsbaustein RG2 eingebbar ist. Ein Eingeben des zweiten Testsignals in den zweiten Spannungsüberwachungsbaustein RG2 bewirkt einen Selbsttest des Spannungsüberwachungsbausteins RG2, woraufhin durch diesen ein gültiges Reset-Signal auf der zweiten Reset-Leitung PON_RES2_L_I ausgegeben wird.

Im normalen Betriebszustand, d.h. die überwachte Spannung U1 liegt innerhalb des vorgesehenen Sollwertebereichs und es werden keine Testsignale über die Eingangsleitungen PON_TEST1_L_O, PON_TEST2_L_O in die Spannungsüberwachungsbausteine RG1, RG2 eingegeben, sind die Ausgaben auf den Reset-Leitungen PON_RES1_L_I, PON_RES2_L_I vom Reset-Signal verschiedene Signale. Eine übliche Form eines vom Reset-Signal verschiedenen Signals auf einer Reset-Leitung ist ein dauerhaft hoher Pegel repräsentierend den logischen Zustand "1", während ein aktives Reset-Signal ein niedriger Pegel repräsentierend den logischen Zustand "0" ist. Diese Eigenschaft einer Signalleitung wird auch als "Low-Aktiv" bezeichnet. Die erfindungsgemäße Schaltungsanordnung ist jedoch auf andere Formen für Signale auf den Reset-Leitungen PON_RES1_L_I, PON_RES2_L_I ohne weiteres anwendbar.

Die Signale der Reset-Leitungen PON_RES1_L_I, PON_RES2_L_I sind Eingabesignale an eine Auswerteschaltung A, während die Signale der Eingangsleitungen PON_TEST1_L_O, PON_TEST2_L_O der Spannungsüberwachungsbausteine RG1, RG2 Ausgabesignale der Auswerteschaltung A sind.

Die Auswerteschaltung A umfaßt erfindungsgemäß mindestens vier Elemente, wobei diese vier Elemente in beliebigen Kombinationen zusammengefaßt werden können. Diese vier Elemente sind im einzelnen
- eine Verknüpfungsschaltung V1, die als Eingabesignale die Signale der ersten Reset-Leitung PON_RES1_L_I und der zweiten Reset-Leitung PON_RES2_L_I und als Ausgabesignal ein daraus mittels logischer UND-Funktion gebildetes resultierendes Reset-Signal PON_RES aufweist,
- ein Reset-Indizien-Register RIR, welches die Signale der ersten Reset-Leitung PON_RES1_L_I und der zweiten Reset-Leitung PON_RES2_L_I zwischenspeichert und zu diesem Zweck eine entsprechende Zahl von Speicherstellen aufweist,
- ein Reset-Test-Register RTR, welches separate Signale auf die Eingangsleitungen PON_TEST1_L_O, PON_TEST2_L_O der Spannungsüberwachungsbausteine RG1, RG2 aufprägt,
- eine Steuerung S, die Steuerinformationen SI an das Reset-Indizien-Register RIR sendet und Zustandsinformationen aus dem Reset-Indizien-Register RIR ausliest und die Diagnose der Spannungsüberwachungsbausteine RG1, RG2 steuert.

Die Auswerteschaltung A kann dabei Bestandteil einer Baugruppe sein - nicht dargestellt. Gemäß einer vorteilhaften Weiterbildung der erfindungsgemäßen Schaltungsanordnung wird die Auswerteschaltung A dann in die Diagnose der Baugruppe mit einbezogen. Dann steuert die Steuerung S beispielsweise gleichzeitig weitere Diagnosesteuerungen, die die Diagnose anderer funktionaler Einheiten der Baugruppe steuern, oder die Steuerung S wird durch eine zentrale Steuerung gesteuert - nicht dargestellt.

Die Auswerteschaltung kann Bestandteil einer modernen applikationsspezifischen integrierten Schaltung - application specific integrated circuit ASIC - sein - nicht dargestellt. Um die Zuverlässigkeit der Auswerteschaltung A und dabei insbesondere der Verknüpfungsschaltung V1 und damit die Hochverfügbarkeit des Gesamtsystems zu gewährleisten, wird dann die Auswerteschaltung A vollständig oder zu Teilen in die Built-In Self Test Verfahren BIST des ASIC einbezogen, die in der Technik wohlbekannt sind - nicht dargestellt.

Das erfindungsgemäße Verfahren zum Überwachen der Spannung U1 läuft in der Steuerung S in den oben bereits beschriebenen Schritten ab.

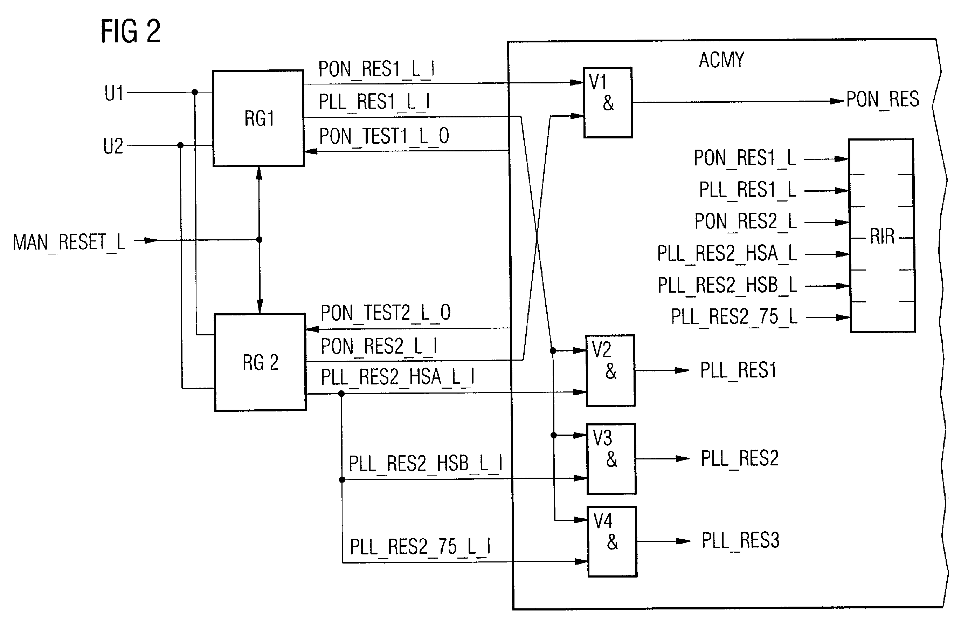

Unter Bezug auf Fig. 2 wird im folgenden eine Anwendung der in Zusammenhang mit Fig. 1 erläuterten Lehren der vorliegenden Erfindung auf eine Speicherbaugruppe eines Prozessors in einem Sprachvermittlungssystem dargestellt.

Fig. 2 zeigt eine erste zu überwachende Spannung U1 und eine zweite zu überwachende Spannung U2, die beide von dem ersten Spannungsüberwachungsbaustein RG1 und dem zweiten Spannungsüberwachungsbaustein RG2 überwacht werden. Für typische Logikbausteine kann so beispielsweise die erste Spannung U1 mit einem Nennwert von 2,5 Volt und die zweite Spannung U2 mit einem Nennwert von 3,3 Volt und dem jeweils zugehörigen ersten und zweiten Sollwertebereich überwacht werden.

Anstatt nur je einer Reset-Leitung weisen beide Spannungsüberwachungsbausteine RG1, RG2 je zwei Reset-Leitungen auf. Bei Abweichung der ersten Spannung U1 vom zugehörigen ersten Sollwertebereich oder bei Abweichung der zweiten Spannung U2 vom zugehörigen zweiten Sollwertebereich sowie beim Einschalten der Spannungsversorgung erzeugt der erste Spannungsüberwachungsbaustein RG1 ein Reset-Signal auf der ersten Reset-Leitung PON_RES1_L_I und auf einer dritten Reset-Leitung PLL_RES1_L_I (für: PLL_Reset1_Low-active_Input), die beide Ausgangsleitungen des ersten Spannungsüberwachungsbausteins RG1 sind. In gleicher Weise erzeugt der zweite Spannungsüberwachungsbaustein RG2 bei Abweichung der ersten Spannung U1 vom zugehörigen ersten Sollwertebereich oder bei Abweichung der zweiten Spannung U2 vom zugehörigen zweiten Sollwertebereich sowie beim Einschalten der Spannungsversorgung ein Reset-Signal auf der zweiten Reset-Leitung PON_RES2_L_I und auf einer weiteren Reset-Leitung, die Signale in insgesamt drei Reset-Leitungen speist: eine vierte Reset-Leitung PLL_RES2_HSA_L_I (für: PLL_Reset2_HighSpeedClockDomainA_Low-active_Input), eine fünfte Reset-Leitung PLL_RES2_HSB_L_I (für: PLL_Reset2_HighSpeedClockDomainB_Low-active_Input) und eine sechste Reset-Leitung PLL_RES2_75_L_I (für: PLL_Reset2_75MhzClockDomain_Low-active_Input).

Aus schaltungstechnischen Erwägungen ist für dieses Ausführungsbeispiel eine Aufteilung der Reset-Signale auf insgesamt sechs Reset-Leitung erforderlich, wie im folgenden erläutert. Ein Baustein ACMY (für: ASIC for Common Memory), für den die Spannungsüberwachung und die Generierung von Power-On-Reset-Signalen durchgeführt wird, ist ein hochkomplexer ASIC, der unter anderem auch drei verschiedene Taktdomänen aufweist, die durch drei - nicht dargestellte - separate Phasenregelschleifen PLL (für: Phase Locked Loop) gesteuert werden. Die Reset-Signale für diese PLL werden über folgende vier Reset-Leitungen geliefert: die dritte Reset-Leitung PLL_RES1_L_I, die vierte Reset-Leitung PLL_RES2_HSA_L_I, die fünfte Reset-Leitung PLL_RES2_HSB_L_I und die sechste Reset-Leitung PLL_RES2_75_L_I, wohingegen die erste Reset-Leitung PON_RES1_L_I und die zweite Reset-Leitung PON_RES2_L_I die Reset-Signale für eine durch die drei PLL getaktete Schaltungslogik liefern.

Sobald die Taktzustände stabil sind, wird die Schaltungslogik in ihren Betriebszustand versetzt. Um dies zu erreichen, wird die Schaltungslogik durch verlängerte Reset-Signale auf der ersten Reset-Leitung PON_RES1_L_I und der zweiten Reset-Leitung PON_RES2_L_I gegenüber den Reset-Signalen der anderen vier Reset-Leitungen später aktiviert als die drei PLL.

Die drei PLL werden mit verschiedenen Reset-Signalen versorgt. Dies liefert Vorteile beim Testen der PLL, da es so möglich ist, jede PLL und damit die von den PLL versorgten Taktdomänen separat zu testen. Auswirkungen auf die erfindungsgemäße Schaltungsanordnung ergeben sich dadurch nur insofern, daß das PLL-Reset-Signal des zweiten Spannungsüberwachungsbausteins RG2 insgesamt drei Reset-Leitungen speist: die vierte Reset-Leitung PLL_RES2_HSA_L_I, die fünfte Reset-Leitung PLL_RES2_HSB_L_I und die sechste Reset-Leitung PLL_RES2_75_L_I.

Der erste Spannungsüberwachungsbaustein RG1 weist, wie schon im Zusammenhang mit Fig. 1 erläutert, die erste Eingangsleitung PON_TEST1_L_O auf, über die das erste Testsignal in den ersten Spannungsüberwachungsbaustein RG1 eingebbar ist. Ein Eingeben des ersten Testsignals in den ersten Spannungsüberwachungsbaustein RG1 bewirkt einen Selbsttest des Spannungsüberwachungsbausteins RG1, woraufhin durch diesen ein gültiges Reset-Signal jeweils auf der ersten Reset-Leitung PON_RES1_L_I und auf der zweiten Reset-Leitung PLL_RES1_L_I ausgegeben wird.

Der erste Spannungsüberwachungsbaustein RG1 weist außerdem eine dritte Eingangsleitung auf, die mit einer zentralen Reset-Leitung MAN_RESET_L verbunden ist. Diese zentrale Reset-Leitung MAN_RESET_L ist beispielsweise mit einer Vorrichtung zum manuellen Auslösen eines Reset verbunden. Ein Eingeben eines gültigen Reset-Signals über die mit der zentralen Reset-Leitung verbundene dritte Eingabeleitung in den ersten Spannungsüberwachungsbaustein RG1 bewirkt das Ausgeben eines gültigen Reset-Signals jeweils auf der ersten Reset-Leitung PON_RES1_L_I und auf der dritten Reset-Leitung PLL_RES1_L_I.

Der zweite Spannungsüberwachungsbaustein RG2 weist, wie schon im Zusammenhang mit Fig. 1 erläutert, die zweite Eingangsleitung PON_TEST2_L_O auf, über die das zweite Testsignal in den zweiten Spannungsüberwachungsbaustein RG2 eingebbar ist. Ein Eingeben des zweiten Testsignals in den zweiten Spannungsüberwachungsbaustein RG2 bewirkt einen Selbsttest des Spannungsüberwachungsbausteins RG2, woraufhin durch diesen ein gültiges Reset-Signal jeweils auf der zweiten Reset-Leitung PON_RES2_L_I, der vierten Reset-Leitung PLL_RES2_HSA_L_I, der fünften Reset-Leitung PLL_RES2_HSB_L_I und der sechsten Reset-Leitung PLL_RES2_75_L_I ausgegeben wird.

Der zweite Spannungsüberwachungsbaustein RG2 weist außerdem eine vierte Eingangsleitung auf, die mit der zentralen Reset-Leitung MAN_RESET_L verbunden ist. Ein Eingeben eines gültigen Reset-Signals über die mit der zentralen Reset-Leitung verbundene vierte Eingabeleitung in den zweiten Spannungsüberwachungsbaustein RG2 bewirkt das Ausgeben eines gültigen Reset-Signals jeweils auf der zweiten Reset-Leitung PON_RES2_L_I, der vierten Reset-Leitung PLL_RES2_HSA_L_I, der fünften Reset-Leitung PLL_RES2_HSB_L_I und der sechsten Reset-Leitung PLL_RES2_75_L_I.

Die genannten sechs Reset-Leitungen sind Eingangsleitungen des ASIC ACMY, von dem nur die für die Spannungsüberwachung und deren Test erforderlichen Elemente dargestellt sind. Die erste Eingabeleitung PON_TEST1_L_O des ersten Spannungsüberwachungsbausteins RG1 und die zweite Eingabeleitung PON_TEST2_L_O des zweiten Spannungsüberwachungsbausteins RG2 sind Ausgabeleitungen des ASIC ACMY.

Die sechs Reset-Leitungen sind innerhalb des ASIC ACMY mit vier Verknüpfungselementen, die dann vier resultierende Reset-Signale liefern, wie folgt verbunden:
- Das Signal der ersten Reset-Leitung PON_RES1_L_I und das Signal der zweiten Reset-Leitung PON_RES2_L_I werden in dem ersten Verknüpfungselement V1 zu dem ersten resultierenden Reset-Signal PON_RES verknüpft.
- Das Signal der dritten Reset-Leitung PLL_RES1_L_I und das Signal der vierten Reset-Leitung PLL_RES2_HSA_L_I werden in einem zweiten Verknüpfungselement V2 zu einem zweiten resultierenden Reset-Signal PLL_RES1 verknüpft.
- Das Signal der dritten Reset-Leitung PLL_RES1_L_I und das Signal der fünften Reset-Leitung PLL_RES2_HSB_L_I werden in einem dritten Verknüpfungselement V3 zu einem dritten resultierenden Reset-Signal PLL_RES2 verknüpft.
- Das Signal der dritten Reset-Leitung PLL_RES1_L_I und das Signal der sechsten Reset-Leitung PLL_RES2_75_L_I werden in einem vierten Verknüpfungselement V4 zu einem vierten resultierenden Reset-Signal PLL_RES3 verknüpft.

Außerdem sind die sechs Reset-Leitungen innerhalb des ASIC ACMY mit den Eingängen des Reset-Indizien-Registers RIR verbunden, welches im Unterschied zu Fig. 1 entsprechend über sechs Eingänge und eine entsprechend größere Anzahl von Speicherstellen verfügt. Dies ist in Fig. 2 schematisch dargestellt. Das Reset-Indizien-Register ist wie in Fig. 1 mit Steuerung S verbunden, was in Fig. 2 im Einzelnen nicht dargestellt ist.

Die Ausgabeleitungen des ASIC ACMY (die erste Eingabeleitung PON_TEST1_L_O und die zweite Eingabeleitung PON_TEST2_L_O) sind innerhalb des ASIC ACMY mit dem Reset-Test-Register RTR aus Fig. 1 verbunden - nicht dargestellt. Das Reset-Test-Register RTR ist mit Steuerung S verbunden - nicht dargestellt.

Das Testverfahren für die Schaltungsanordnung gemäß Fig. 2 entspricht dem für die Schaltungsanordnung gemäß Fig. 1 beschriebenen, mit Modifikationen in Schritten vier und fünf. Die Modifikationen betreffen den Umstand, daß die Schaltungsanordnung gemäß Fig. 2 zwei Reset-Leitungen für den ersten Spannungsüberwachungsbaustein RG1 aufweist und vier Reset-Leitungen für den zweiten Spannungsüberwachungsbaustein RG2. Dementsprechend sind in den Schritten vier und fünf des Verfahrens zwei bzw. vier Reset-Leitungen zu berücksichtigen, die nach Ablauf verschiedener Zeitspannen zu einem beliebigen gültigen, vom Reset-Signal unterschiedlichen Signal zurückkehren, d.h. in Schritt fünf sind verschiedene Zeitspannen für verschiedene Reset-Leitungen des gleichen Bausteins vorzusehen.

Die im bevorzugten Ausführungsbeispiel eingesetzten Verknüpfungselemente V1, V2, V3 und V4 realisieren die logische UND Funktion bezogen auf gültige Reset-Signale. Da gültige Reset-Signale durch den logischen Zustand "0" repräsentiert werden können, z.B. im Fall low-aktiver Signalleitungen, muß beim Schaltungsentwurf eine entsprechend an die vorliegenden Eingangssignale und die gewünschten Ausgangssignale angepaßte schaltungstechnische Realisierung gewählt werden. Verfahren zum Entwurf von Schaltungslogiken und Schaltungsanordnungen zum Realisieren logischer Funktionen, beispielsweise für lowaktive Logikschaltungen, sind in der Technik wohlbekannt, so daß das die vorliegende Erfindung jeweils den konkreten Gegebenheiten ohne weiteres angepaßt werden kann.

## Patentansprüche

1. Schaltungsanordnung zur Überwachung physikalischer Grössen (U1, U2), umfassend:
- einen ersten Überwachungsbaustein (RG1) zur Überwachung mindestens einer physikalischen Größe (U1, U2) mit Mitteln zur Zuführung eines Signals bei Abweichung der überwachten physikalischen Größe (U1, U2) von deren vorgegebenem Sollwertebereich über erste Ausgabesignalleitungsmittel (PON_RES1_L_I) zu einer Auswerteschaltung (A) und ersten Eingabesignalleitungsmitteln (PON_TEST1_L_O) zur Eingabe eines ersten Testsignals, wobei durch das erste Testsignal derselbe Zustandswechsel des ersten Überwachungsbausteins (RG1) erzeugbar ist wie durch eine Abweichung der überwachten physikalischen Größe von ihrem Sollwertebereich,
- mindestens einen weiteren Überwachungsbaustein (RG2) zur Überwachung der gleichen physikalischen Größe (U1, U2) mit Mitteln zur Zuführung eines Signals bei Abweichung der überwachten physikalischen Größe (U1, U2) von deren vorgegebenem Sollwertebereich über weitere Ausgabesignalleitungsmittel (PON_RES2_L_I) zu der Auswerteschaltung (A) und weiteren Eingabesignalleitungsmitteln (PON_TEST2_L_O) zur Eingabe eines weiteren Testsignals, wobei durch das weitere Testsignal derselbe Zustandswechsel des weiteren Überwachungsbausteins (RG2) erzeugbar ist wie durch eine Abweichung der überwachten physikalischen Größe von ihrem Sollwertebereich,
- der Auswerteschaltung (A) zugeordnete Verknüpfungsmittel (V1) zur Verknüpfung der über die ersten Ausgabesignalleitungsmittel (PON_RES1_L_I) und die weiteren Ausgabesignalleitungsmittel (PON_RES2_L_I) zugeführten Signale zu einem resultierenden Ausgabesignal (PON_RES),
- der Auswerteschaltung (A) zugeordnete erste Registermittel (RTR) zum separaten Aufprägen des ersten Testsignals auf die ersten Eingabesignalleitungsmittel (PON_TEST1_L_O) und des zweiten Testsignals auf die weiteren Eingabesignalleitungsmittel (PON_TEST2_L_O), wobei die ersten Registermittel (RTR) Mittel zum Empfang von Steuerungsinformationen (SI) von Steuerungsmitteln (S) aufweisen,
- der Auswerteschaltung (A) zugeordnete zweite Registermittel (RIR), die an die ersten Ausgabesignalleitungsmittel (PON_RES1_L_I) und die weiteren Ausgabesignalleitungsmittel (PON_RES2_L_I) angeschlossen sind und Mittel zur Übertragung von Zustandsinformationen (ZI) an die Steuerungsmittel (S) aufweisen,
- die der Auswerteschaltung (A) zugeordneten Steuerungsmittel (S), die Mittel zum Auswerten von Zustandsinformationen (ZI) der zweiten Registermittel (RIR) und Mittel zum Senden von Steuerungsinformationen (SI) an die ersten Registermittel (RTR) umfassen.

2. Schaltungsanordnung nach Anspruch 1,
**dadurch gekennzeichnet,**
**daß** das Verknüpfungsmittel (V1) ein die logische UND-Funktion realisierendes Gatter ist.

3. Schaltungsanordnung nach einem der Ansprüche 1 oder 2,
**dadurch gekennzeichnet,**
**daß** die Auswerteschaltung (A) Teil einer Baugruppe ist, wobei die Auswerteschaltung (A) Bestandteil einer Diagnosestrategie der Baugruppe ist.

4. Schaltungsanordnung nach einem der Ansprüche 1 oder 2
**dadurch gekennzeichnet,**
**daß** die Auswerteschaltung (A) Teil einer applikationsspezifischen integrierten Schaltung - Application Specific Integrated Circuit ASIC - ist, wobei die Auswerteschaltung (A) durch den integrierten Selbsttest - Built-In Self Test BIST - des ASIC umfaßt ist.

5. Schaltungsanordnung nach einem der Ansprüche 1 bis 4,
**dadurch gekennzeichnet,**
**daß** die mindestens eine überwachte physikalische Größe (U1, U2) eine beliebige Auswahl physikalischer Größen ist, bei deren Abweichung vom vorgegebenen Sollwertebereich ein Rücksetzsignal erzeugbar ist.

6. Schaltungsanordnung nach einem der Ansprüche 1 bis 5,
**dadurch gekennzeichnet,**
**daß** die mindestens eine überwachte physikalische Größe (U1 eine beliebige Auswahl aus den Größen elektrische Spannung, elektrischer Strom und Temperatur ist.

7. Schaltungsanordnung nach einem der Ansprüche 1 bis 6,
**dadurch gekennzeichnet,**
**daß** die mindestens eine überwachte physikalische Größe eine Auswahl mindestens zweier elektrischer Spannungen (U1, U2) ist, die jeweils durch beide Überwachungsbausteine (RG1, RG2) überwacht werden.

8. Schaltungsanordnung nach einem der Ansprüche 1 bis 7,
**dadurch gekennzeichnet,**
**daß** die Überwachungsbausteine (RG1, RG2) jeweils mehrere Ausgabesignalleitungsmittel (PON_RES_1_L_I, PLL_RES1_L_I, PON_RES2_L_I, PLL_RES2_HSA_L_I, PLL_RES2_HSB_L_I, PLL_RES2_75_L_I) aufweisen, wobei die über die mehreren Ausgabesignalleitungsmittel desselben Überwachungsbausteins (RG1, RG2) übertragenen Signale jeweils ein eigenes Zeitverhalten aufweisen.

9. Verfahren zur Überwachung mindestens einer physikalischen Größe (U1), demgemäß
- die physikalische Größe (U1) durch einen ersten Überwachungsbaustein (RG1) überwacht wird, wobei durch den ersten Überwachungsbaustein (RG1) bei Abweichung der überwachten physikalischen Größe (U1) von deren vorgegebenem Sollwertebereich ein Signal über erste Ausgabesignalleitungsmittel (PON_RES1_L_I) zu einer Auswerteschaltung (A) geliefert wird,
- in den ersten Überwachungsbaustein (RG1) über erste Eingabesignalleitungsmittel (PON_TEST1_L_O) ein erstes Testsignal eingebbar ist, wobei das erste Testsignal denselben Zustandswechsel des ersten Überwachungsbausteins (RG1) hervorruft wie eine Abweichung der überwachten physikalischen Größe von ihrem Sollwertebereich,
- die physikalische Größe (U1) durch mindestens einen weiteren Überwachungsbaustein (RG2) überwacht wird, wobei durch den weiteren Überwachungsbaustein (RG2) bei Abweichung der überwachten physikalischen Größe (U1) von deren vorgegebenem Sollwertebereich ein Signal über weitere Ausgabesignalleitungsmittel (PON_RES2_L_I) zu der Auswerteschaltung (A) geliefert wird,
- in den weiteren Überwachungsbaustein (RG2) über weitere Eingabesignalleitungsmittel (PON_TEST2_L_O) ein zweites Testsignal eingebbar ist, wobei das zweite Testsignal denselben Zustandswechsel des weiteren Überwachungsbausteins (RG2) hervorruft wie eine Abweichung der überwachten physikalischen Größe von ihrem Sollwertebereich,
- die über die ersten Ausgabesignalleitungsmittel (PON_RES1_L_I) und die weiteren Ausgabesignalleitungsmittel (PON_RES2_L_I) der Auswerteschaltung (A) zugeführten Signale durch Verknüpfungsmittel (V1), die Bestandteil der Auswerteschaltung A sind, zu einem resultierenden Ausgabesignal (PON_RES) verknüpft werden,
- durch die Auswerteschaltung (A) mittels erster Registermittel (RTR) das erste und das zweite Testsignal separat auf die ersten Eingabesignalleitungsmittel (PON_TEST1_L_O) und die weiteren Eingabesignalleitungsmittel (PON_TEST2_L_O) aufprägbar sind, wobei durch die ersten Registermittel (RTR) Steuerungsinformationen (SI) von Steuerungsmitteln (S) ausgewertet werden,
- durch die Auswerteschaltung (A) mittels zweiter Registermittel (RIR) Signale der ersten Ausgabesignalleitungsmittel (PON_RES1_L_I) und der weiteren Ausgabesignalleitungsmittel (PON_RES2_L_I) abgegriffen werden und Zustandsinformationen (ZI) an die Steuerungsmittel (S) übertragen werden,
- durch die Auswerteschaltung (A) mittels der Steuerungsmittel (S) die Zustandsinformationen (ZI) der zweiten Registermittel (RIR) ausgewertet werden und Steuerungsinformationen (SI) an die ersten Registermittel (RTR) gesendet werden.

10. Verfahren nach Anspruch 9,
**dadurch gekennzeichnet,**
**daß** ein Testen der Überwachungsbausteine (RG1, RG2) durchgeführt wird, indem
- in einem ersten Schritt durch die Steuerungsmittel (S) der erste Überwachungsbaustein (RG1) ausgewählt wird,
- in einem zweiten Schritt diese Auswahl repräsentierende Steuerungsinformationen (SI) an die ersten Registermittel (RTR) übertragen werden,
- in einem dritten Schritt das erste Testsignal mittels der ersten Eingabesignalleitungsmittel (PON_TEST1_L_O) an den ersten Überwachungsbaustein (RG1) übertragen wird,
- in einem vierten Schritt die von den zweiten Registermitteln (RIR) erzeugten Zustandsinformationen (ZI), welche die Signale der Ausgabesignalleitungsmittel (PON_RES1_L_I, PON_RES2_L_I) repräsentieren, durch die Steuerungsmittel (S) empfangen und daraufhin überprüft werden, daß das Signal der ersten Ausgabesignalleitungsmittel (PON_RES1_L_I) ein gültiges Reset-Signal bzw. Rücksetzsignal ist und daß das Signal der weiteren Ausgabesignalleitungsmittel (PON_RES2_L_I) ein beliebiges gültiges, vom Reset-Signal unterschiedliches Signal ist,
- in einem fünften Schritt nach Ablauf einer vorgebbaren Zeitspanne, deren Ablauf mit dem Feststellen eines gültigen Reset-Signals in Schritt vier beginnt, durch die Steuerungsmittel (S) überprüft wird, daß das Signal der ersten Ausgabesignalleitungsmittel (PON_RES1_L_I) zu einem beliebigen gültigen, vom Reset-Signal unterschiedlichen Signal zurückkehrt,
- die Schritte eins bis fünf für alle weiteren Überwachungsbausteine (RG2) entsprechend wiederholt werden.

11. Verfahren nach einem der Ansprüche 9 oder 10,
**dadurch gekennzeichnet,**
**daß** in dem Verknüpfungsmittel (V1) die der Auswerteschaltung (A) über die ersten Ausgabesignalleitungsmittel (PON_RES1_L_I) und die weiteren Ausgabesignalleitungsmittel (PON_RES2_L_I) zugeführten Signale gemäß der logischen UND-Funktion verknüpft werden.

12. Verfahren nach einem der Ansprüche 9 bis 1,
**dadurch gekennzeichnet,**
**daß** die Auswerteschaltung (A) von einer Diagnosestrategie einer Baugruppe, deren Bestandteil die Auswerteschaltung (A) ist, umfaßt wird.

13. Verfahren nach einem der Ansprüche 9 bis 11,
**dadurch gekennzeichnet,**
**daß** die Auswerteschaltung (A) von einem Verfahren für einen integrierten Selbsttest - Built-In Self Test BIST - einer applikationsspezifischen integrierten Schaltung - Application Specific Integrated Circuit ASIC - , deren Bestandteil die Auswerteschaltung (A) ist, umfaßt wird.

14. Verfahren nach einem der Ansprüche 9 bis 13,
**dadurch gekennzeichnet,**
**daß** die mindestens eine überwachte physikalische Größe (U1) aus einer beliebigen Auswahl physikalischer Größen gebildet wird, bei denen eine Abweichung vom vorgegebenen Sollwertebereich ein Rücksetzsignal erzeugbar ist.

15. Verfahren nach einem der Ansprüche 9 bis 14,
**dadurch gekennzeichnet,**
**daß** die mindestens eine überwachte physikalische Größe (U1 aus einer beliebigen Auswahl aus den Größen elektrische Spannung, elektrischer Strom und Temperatur gebildet wird.

16. Verfahren nach einem der Ansprüche 9 bis 15,
**dadurch gekennzeichnet,**
**daß** die mindestens eine überwachte physikalische Größe aus einer Auswahl mindestens zweier elektrischer Spannungen (U1, U2) gebildet wird, die jeweils durch beide Überwachungsbausteine (RG1, RG2) überwacht werden.

17. Verfahren nach einem der Ansprüche 9 bis 16,
**dadurch gekennzeichnet,**
**daß** durch die Überwachungsbausteine (RG1, RG2) jeweils Signale mittels mehrerer Ausgabesignalleitungsmittel (PON_RES_1_L_I, PLL_RES1_L_I, PON_RES2_L_I, PLL_RES2_HSA_L_1, PLL_RES2_HSB_L_I, PLL_RES2_75_L_I) ausgegeben werden, wobei die über die mehreren Ausgabesignalleitungsmittel desselben Überwachungsbausteins (RG1, RG2) übertragenen Signale jeweils ein eigenes Zeitverhalten aufweisen.
